# EUROPEAN PATENT APPLICATION

(11) **EP 3 496 002 A1**
(43) Date of publication of application: **12.06.2019**
(21) Application number: 18210347.3
(22) Date of filing: 05.12.2018
(51) Int. Cl.: G06K 9/18

(54) **MAGNETIC-INK-CHARACTER RECOGNIZING DEVICE AND COMPUTER PROGRAM**

(30) Priority: 08.12.2017 JP 2017236283
(71) Applicant: Toshiba TEC Kabushiki Kaisha, 141-8562 Tokyo (JP)
(72) Inventor: IWASAKI, Fumiharu, Shinagawa-ku, Tokyo 141-8562 (JP)
(74) Representative: Fédit-Loriot

(57) **Abstract**

A magnetic-ink-character recognizing device includes a magnetic head, a conveying section configured to convey a medium on which magnetic ink characters are printed, an acquiring section configured to acquire a magnetism detection signal read by the magnetic head, a segmenting section configured to segment waveform data of the magnetic ink characters from the magnetism detection signal, a first calculating section configured to compare the waveform data segmented by the segmenting section and reference waveform data and calculate similarities of both the data, respectively, a second calculating section configured to compare the waveform data segmented by the segmenting section and extended waveform data obtained by compressing or expanding length in a time axis direction of the reference waveform data and calculate similarities of both the data, respectively, and a recognizing section configured to recognize the magnetic ink characters of the waveform data segmented by the segmenting section.

## Description

### FIELD

Embodiments described herein relate generally to a magnetic-ink-character recognizing device, a magnetic ink character recognizing method and a computer program.

### BACKGROUND

A magnetic-ink-character recognizing device such as a MICR (Magnetic Ink Character Reader) that reads, using a magnetic head, magnetic ink characters printed on paper is known. For example, a magnetic-ink-character recognizing device of a paper conveyance type performs reading with a magnetic head while conveying paper on which magnetic ink characters are printed and recognizes the magnetic ink characters on the basis of a magnetism detection signal output from the magnetic head.

The magnetism detection signal is represented by waveform data of two dimensions including a time axis and a voltage axis. Recognition of characters is performed by comparing the magnetism detection signal with waveform data (template data) standardized by ISO1004 or the like. There has been proposed a technique for preparing template data of characters for each of types of the characters obtained by changing character widths of the characters, thicknesses of lines, and the like and comparing the template and a magnetism detection waveform to recognize the characters of the template data having similarities equal to or larger than a threshold as read characters.

Incidentally, the magnetic-ink-character recognizing device explained above is configured to convey the paper at predetermined speed. However, the conveying speed sometimes fluctuates because of various reasons. For example, if a conveying roller for paper conveyance is formed of rubber or the like, the diameter of the conveying roller changes with temperature. The conveying speed sometimes fluctuates according to the change in the diameter of the conveying roller. If the conveying speed fluctuates, since deviation occurs in the length in a time axis direction of the magnetism detection signal read by the magnetic head, it is likely that the characters cannot be recognized using the standardized template. In the related art explained above, a recognition rate of the characters having the changed character widths and the changed thicknesses of the lines can be improved. However, it is likely that the magnetism detection signal having the changed length in the time axis direction cannot be recognized.

Related art is described in, for example, JP-A-2011-54029.

### SUMMARY OF INVENTION

To solve the above-cited problems, there is provided a magnetic-ink-character recognizing device comprising:
a magnetic head;
a conveying section configured to convey, relative to the magnetic head, a medium on which magnetic ink characters are printed;
an acquiring section configured to acquire a magnetism detection signal read by the magnetic head;
a segmenting section configured to segment waveform data of the magnetic ink characters from the magnetism detection signal;
a first calculating section configured to compare, on the basis of a storing section having stored therein reference waveform data of characters, the waveform data segmented by the segmenting section and the reference waveform data and calculate similarities between the reference waveform data and the segmented waveform data;
a second calculating section configured to compare the waveform data segmented by the segmenting section and extended waveform data obtained by compressing or expanding length in a time axis direction of the reference waveform data according to fluctuation in a conveyance amount of the medium and calculate similarities between the segmented waveform data and the extended waveform data; and
a recognizing section configured to recognize, on the basis of the similarities calculated by the first calculating section and the second calculating section, the magnetic ink characters of the waveform data segmented by the segmenting section.

Preferably the storing section may store, for each of the characters, the reference waveform data and the extended waveform data of the reference waveform data in association with each other, and
the second calculating section may compare the waveform data segmented by the segmenting section with the extended waveform data stored in the storing section.

Preferably the magnetic-ink-character recognizing device may further comprise:
a generating section configured to generate the extended waveform data on the basis of the reference waveform data of the characters,
wherein the second calculating section may compare the waveform data segmented by the segmenting section with the extended waveform data generated by the generating section.

Preferably the extended waveform data may be obtained by compressing or expanding a part or all of the reference waveform data in the time axis direction.

Preferably the extended waveform data may be obtained by, concerning each of the reference waveform data, similarities between which are likely to increase according to compression or expansion in the time axis direction, compressing or expanding length in the time axis direction of the reference waveform data in a deforming direction in which the similarities decrease.

Preferably the magnetism detection signal may be represented by waveform data of a time axis dimension and a voltage axis dimension.

Preferably the magnetism detection signal may represent characteristics of the magnetic ink characters.

Preferably the characteristics of the magnetic ink characters may comprise shapes of the magnetic ink characters.

Preferably the reference waveform data of characters may be waveform data obtained when the magnetic ink characters are read at a predetermined speed.

In another exemplary embodiment, there is also provided a magnetic ink character recognizing method, comprising:
acquiring a magnetism detection signal read by a magnetic head on a medium on which magnetic ink characters are printed;
segmenting waveform data of magnetic ink characters from the magnetism detection signal;
comparing, on the basis of a storing section having stored therein reference waveform data of characters, the segmented waveform data and the reference waveform data and calculating similarities between the reference waveform data and the segmented waveform data;
comparing the segmented waveform data and extended waveform data obtained by compressing or expanding length in a time axis direction of the reference waveform data according to fluctuation in a conveyance amount of the medium and calculating similarities between the segmented waveform data and the extended waveform data; and
recognizing, on the basis of the calculated similarities, the magnetic ink characters of the segmented waveform data.

Preferably the method may further comprise:
comparing the waveform data segmented by the segmenting section with the extended waveform data stored in the storing section.

Preferably the method may further comprise:
generating the extended waveform data on the basis of the reference waveform data of the characters, and
comparing the waveform data segmented by the segmenting section with the extended waveform data generated.

Preferably the method may further comprise:
obtaining the extended waveform data by compressing or expanding a part or all of the reference waveform data in the time axis direction.

Preferably the method may further comprise:
obtaining the extended waveform data by, concerning each of the reference waveform data, similarities between which are likely to increase according to compression or expansion in the time axis direction, compressing or expanding length in the time axis direction of the reference waveform data in a deforming direction in which the similarities decrease.

Preferably yet the magnetism detection signal may be represented by waveform data of a time axis dimension and a voltage axis dimension.

Preferably still the magnetism detection signal may represent characteristics of the magnetic ink characters.

Preferably the characteristics of the magnetic ink characters may comprise shapes of the magnetic ink characters.

Preferably the reference waveform data of characters may be waveform data obtained when the magnetic ink characters are read at a predetermined speed.

In yet another exemplary embodiment, there is also provided a non-transitory computer readable storage medium storing a program causing a computer to execute the method according to any one of the preceding embodiments.

### DESCRIPTION OF THE DRAWINGS

The above and other objects, features and advantages of the present invention will be made apparent from the following description of the preferred embodiments, given as non-limiting examples, with reference to the accompanying drawings, in which:
FIG. 1 is a diagram illustrating a schematic configuration of a magnetic-ink-character recognizing device according to an embodiment;
FIG. 2 is a diagram illustrating an example of paper according to the embodiment;
FIG. 3 is a diagram illustrating an example of a magnetism detection signal of the paper according to the embodiment;
FIG. 4 is a diagram illustrating an example of hardware components included in the magnetic-ink-character recognizing device;
FIG. 5 is a diagram schematically illustrating an example of a data configuration of template data according to the embodiment;
FIG. 6 is a diagram illustrating an example of functional components included in the magnetic-ink-character recognizing device; and
FIG. 7 is a flowchart illustrating an example of character recognition processing performed by the magnetic-ink-character recognizing device.

### DETAILED DESCRIPTION

An object is to provide a magnetic-ink-character recognizing device and a computer program capable of improving a character recognition rate.

A magnetic-ink-character recognizing device in an embodiment includes a magnetic head, a conveying section, an acquiring section, a segmenting section, a first calculating section, a second calculating section, and a recognizing section. The conveying section conveys, relatively to the magnetic head, a medium on which magnetic ink characters are printed. The acquiring section acquires a magnetism detection signal read by the magnetic head. The segmenting section segments waveform data of the magnetic ink characters from the magnetism detection signal. The first calculating section compares, on the basis of a storing section having stored therein reference waveform data of characters, the waveform data segmented by the segmenting section and the reference waveform data and calculates similarities of both the data, respectively. The second calculating section compares the waveform data segmented by the segmenting section and extended waveform data obtained by compressing or expanding length in a time axis direction of the reference waveform data according to fluctuation in a conveyance amount of the medium and calculates similarities of both the data, respectively. The recognizing section recognizes, on the basis of the similarities calculated by the first calculating section and the second calculating section, the magnetic ink characters of the waveform data segmented by the segmenting section.

A magnetic-ink-character recognizing device and a computer program according to an embodiment are explained in detail below with reference to the accompanying drawings.

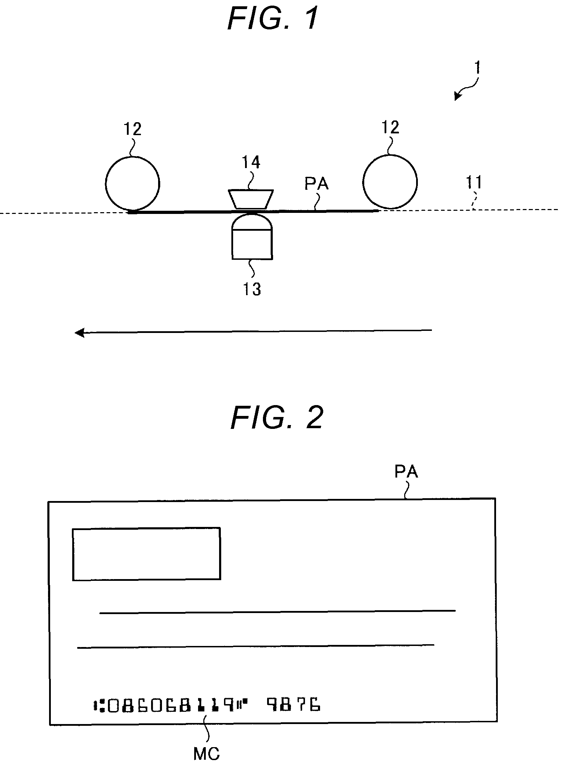

FIG. 1 is a diagram illustrating a schematic configuration of the magnetic-ink-character recognizing device. As illustrated in FIG. 1, a magnetic-ink-character recognizing device 1 includes a paper conveying path 11, a conveying roller 12, a magnetic head 13, and a paper presser 14.

The paper conveying path 11 is a conveying path for conveying paper PA, which is a medium. The paper PA is a medium (a paper sheet) such as a check or a promissory note. Magnetic ink characters MC (see FIG. 2) are printed on the surface of the paper PA.

FIG. 2 is a diagram illustrating an example of the paper PA. As illustrated in FIG. 2, information such as a check number is printed on the surface of the paper PA as the magnetic ink characters MC. Such magnetic ink characters MC are printed in a font conforming to a standard such as E-13B or CMC-7. The paper PA is inserted into the paper conveying path 11 from the left end side illustrated in FIG. 2.

Referring back to FIG. 1, the conveying roller 12 conveys the paper PA, which is inserted from the right end side of the paper conveying path 11, to the left end side of the paper conveying path 11. The magnetic head 13 is a magnetism detecting device that reads a change in magnetism (a magnetic field). The magnetic head 13 reads magnetism from the paper PA (the magnetic ink characters MC) conveyed on the paper conveying path 11. The paper presser 14 is disposed to be opposed to the magnetic head 13. During a reading operation, the paper presser 14 presses the paper PA in a head direction with a certain fixed pressure. The paper PA conveyed on the paper conveying path 11 passes through a gap between the magnetic head 13 and the paper presser 14.

In the configuration illustrated in FIG. 1, the paper PA is inserted from the right end side of the paper conveying path 11 such that the magnetic ink characters MC are opposed to the magnetic head 13. The inserted paper PA is conveyed to the left end side of the paper conveying path 11 by the conveying roller 12. The magnetic head 13 reads the magnetic ink characters MC in this conveying process and outputs a result of the reading as a magnetism detection signal.

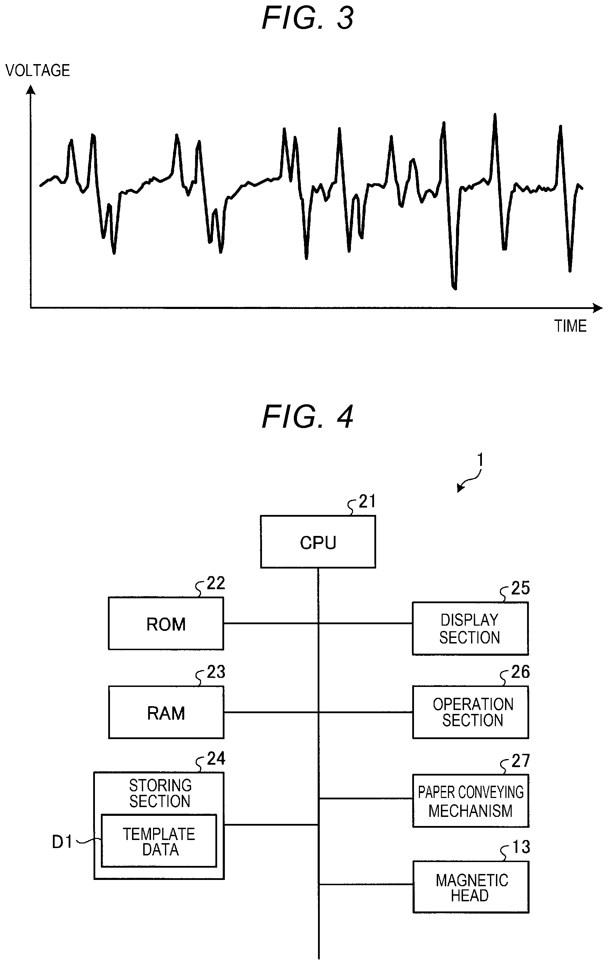

If the magnetic ink characters MC are read by the magnetic head 13, a magnetism detection signal illustrated in FIG. 3 is obtained. FIG. 3 is a diagram illustrating an example of the magnetism detection signal. In FIG. 3, the horizontal axis is a time axis representing an elapse of time and the vertical axis represents a voltage value corresponding to the magnitude of magnetism. In this way, the magnetism detection signal is represented by waveform data of two dimensions including the time axis and the voltage axis . The magnetism detection signal represents characteristics (shapes) of the magnetic ink characters MC. The magnetic-ink-character recognizing device 1 compares a waveform of the magnetism detection signal and a waveform of template data explained below to perform recognition of the magnetic ink characters MC.

The configuration related to the conveyance of the paper PA is not limited to the configuration illustrated in FIG. 1. For example, the paper conveying path 11 is formed in linear shape in FIG. 1. However, the paper conveying path 11 may be formed as a curve. A magnet for magnetization may be provided on an upstream side or the like of the magnetic head 13 to magnetize the magnetic ink characters MC prior to the reading by the magnetic head 13. In FIG. 1, the magnetic head 13 is set in a fixed position and the paper PA is conveyed (moved) with respect to the magnetic head 13. However, the paper PA may be set in a fixed position and the magnetic head 13 may be conveyed (moved) with respect to the paper PA.

Hardware components of the magnetic-ink-character recognizing device 1 are explained with reference to FIG. 4. FIG. 4 is a diagram illustrating an example of hardware components included in the magnetic-ink-character recognizing device 1.

As illustrated in FIG. 4, the magnetic-ink-character recognizing device 1 includes computer components such as a CPU (Central Processing Unit) 21, a ROM (Read Only Memory) 22, and a RAM (Random Access Memory) 23 together with the magnetic head 13 explained with reference to FIG. 1.

The CPU 21 executes a computer program stored in the ROM 22 to collectively control the operation of the magnetic-ink-character recognizing device 1. The CPU 21 executes computer programs stored in the ROM 22 to realize functional sections explained below.

The ROM 22 stores various computer programs executable by the CPU 21 and various kinds of setting information according to the operation of the magnetic-ink-character recognizing device 1. The RAM 23 temporarily stores data and computer programs when the CPU 21 executes the various computer programs.

The magnetic-ink-character recognizing device 1 includes a storing section 24, a display section 25, and an operation section 26. The storing section 24 is a read-writable nonvolatile memory such as an HDD (Hard Disk Drive) or a flash memory. The storing section 24 stores the various computer programs executable by the CPU 21 and the various kinds of setting information related to the operation of the magnetic-ink-character recognizing device 1.

In order to recognize the magnetic ink characters MC read by the magnetic head 13, the storing section 24 stores template data of characters used for comparison with a magnetism detection signal. The template data is an example of the storing section. The template data is a data table that associates, for each of characters set as targets of recognition, waveform data serving as a reference (reference waveform data) and extended waveform data obtained by compressing or expanding the length in the time axis direction of the reference waveform data.

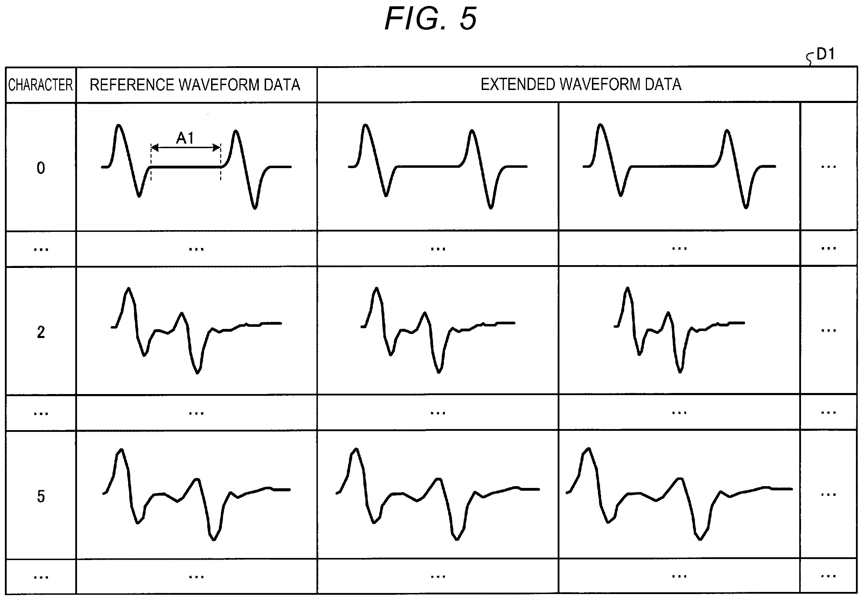

FIG. 5 is a diagram schematically illustrating an example of a data configuration of the template data. As illustrated in FIG. 5, template data D1 stores, for each of types of characters, reference waveform data and extended waveform data in association with each other. The reference waveform data is waveform data of characters standardized by ISO1004 or the like and is waveform data obtained when the magnetic ink characters MC are read at predetermined speed.

The extended waveform data is waveform data obtained by compressing or expanding the waveform of the reference waveform data in the time axis direction according to fluctuation in conveying speed (a conveyance amount) of the paper PA. The template data D1 stores a plurality of kinds of extended waveform data for each of the characters. For example, in extended waveform data of a character "0", extended waveform data on the left is waveform data obtained by compressing the waveform of the reference waveform data in the time axis direction. Extended waveform data on the right is waveform data obtained by expanding the waveform of the reference waveform data in the time axis direction.

The number of extended waveform data stored in association with the characters is not particularly limited. Any number of extended waveform data can be stored. For example, the extended waveform data may be prepared for each of fluctuation patterns of conveying speed assumed from the configuration of the magnetic-ink-character recognizing device 1.

The extended waveform data may be extended waveform data obtained by compressing or expanding the entire waveform of the reference waveform data in the time axis direction or may be waveform data obtained by compressing or expanding a part of the waveform of the reference waveform data in the time axis direction. For example, the extended waveform data of the character "0" is waveform data obtained by compressing or expanding a part (a range of A1 in FIG. 5) of the waveform of the reference waveform data in the time axis direction.

A pitch of the compression or expansion in the time axis direction is desirably set according to the configuration of the magnetic-ink-character recognizing device 1. For example, if the conveying roller 12 related to the conveyance of the paper PA is formed of an elastic body such as rubber, the pitch of the compression or expansion may be set on the basis of a change amount of a roller diameter due to temperature. For example, if a stepping motor is used as a conveying motor related to the conveyance of the paper PA, the pitch of the compression or expansion may be set on the basis of conditions such as an excitation method of the stepping motor, a conveyance pitch, a character width per character, and the number of times of reading per character.

Incidentally, in some cases, like characters "2" and "5" or the like illustrated in FIG. 5, waveform data obtained by compressing or expanding reference waveform data of one character is similar to a waveform of reference waveform data of the other character. For example, in the case of the character "2" and the character "5", if reference waveform data of the character "2" is expanded in the time axis direction, similarity to reference waveform data of the character "5" increases. If the reference waveform data of the character "5" is compressed in the time axis direction, similarity to the reference waveform data of the character "2" increases. Concerning such characters having similarities in the shapes of the waveforms (hereinafter, similar characters), if deformation in the time axis direction is carelessly performed, misreading is likely to increase.

Therefore, concerning the similar characters, in order to reduce occurrence of misreading, it is desirable to deform the reference waveform data of the similar characters in a deforming direction in which the similarities decrease. For example, concerning the character "2", as illustrated in FIG. 5, waveform data obtained by deforming the reference waveform data in a deforming direction in which the similarity to the character "5" decreases, that is, waveform data obtained by compressing the reference waveform data in the time axis direction is prepared. Concerning the character "5", as illustrated in FIG. 5, waveform data obtained by deforming the reference waveform data in a deforming direction in which the similarity to the character "2" decreases, that is, waveform data obtained by expanding the reference waveform data in the time axis direction is prepared. In this way, concerning the similar characters, occurrence of misreading of the similar characters can be reduced by setting, as the extended waveform data, waveform data obtained by deforming the reference waveform data in the deforming direction in which the similarity decreases.

Referring back to FIG. 4, the display section 25 is a display device such as an LCD (Liquid Crystal Display). The display section 25 displays various kinds of information under the control by the CPU 21. The operation section 26 is an input device such as an operation switch. The operation section 26 receives user operation via an operation switch and outputs input operation content to the CPU 21.

The magnetic-ink-character recognizing device 1 includes a paper conveying mechanism 27, which is an example of the conveying section. The paper conveying mechanism 27 includes, together with the paper conveying path 11 and the conveying roller 12, a conveying motor for rotating the conveying roller 12. The paper conveying mechanism 27 conveys, under the control by the CPU 21, the paper PA inserted into the paper conveying path 11 on the paper conveying path 11.

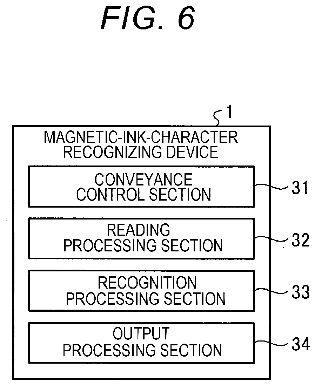

Functional components of the magnetic-ink-character recognizing device 1 are explained with reference to FIG. 6. FIG. 6 is a diagram illustrating an example of functional components included in the magnetic-ink-character recognizing device 1.

As illustrated in FIG. 6, the magnetic-ink-character recognizing device 1 includes, as functional sections, a conveyance control section 31, a reading processing section 32, a recognition processing section 33, and an output processing section 34. The functional sections may be software components realized by cooperation of the CPU 21 and computer programs or may be hardware components realized by a dedicated processor.

The conveyance control section 31 controls the paper conveying mechanism 27 to control the conveyance of the paper PA on the paper conveying path 11. Specifically, if the paper PA is inserted from the right end side of the paper conveying path 11 illustrated in FIG. 1, the conveyance control section 31 causes the paper conveying mechanism 27 to convey the paper PA toward the left end side of the paper conveying path 11.

The reading processing section 32 is an example of the reading section. The reading processing section 32 cooperates with the magnetic head 13 to read the magnetic ink characters MC printed on the paper PA. Specifically, while the paper PA is conveyed according to the control by the conveyance control section 31, the reading processing section 32 operates the magnetic head 13 to acquire a magnetism detection signal output from the magnetic head 13.

The recognition processing section 33 is an example of the segmenting section, the first calculating section, the second calculating section, and the recognizing section. The recognition processing section 33 executes, on the basis of the magnetism detection signal acquired by the reading processing section 32 and the template data stored in the storing section 24, recognition processing for recognizing the magnetic ink characters MC printed on the paper PA.

Specifically, the recognition processing section 33 segments waveform data of a character portion of the magnetic ink characters MC from the magnetism detection signal. A method of segmenting a character is not particularly limited. A publicly-known technique can be used. For example, the recognition processing section 33 detects a peak position of a waveform (a voltage value) from the magnetism detection signal, calculates a start position of a character on the basis of the peak position, and segments a waveform in a predetermined signal range as waveform data for one character. The peak position can be detected on the basis of a predetermined threshold. The signal range related to the segmentation of the character is desirably excessively secured before and after an original signal range for one character on the basis of a predicted fluctuation amount of conveying speed.

After segmenting waveform data of characters, the recognition processing section 33 compares the waveform data and the template data stored in the storing section 24 and performs character recognition on the basis of similarities of the waveform data and the template data. Specifically, the recognition processing section 33 compares the segmented waveform data and the reference waveform data and the extended waveform data included in the template data to calculate similarities of both the data, respectively. The recognition processing section 33 determines whether maximum similarity among the calculated similarities exceeds a predetermined threshold. If determining that the maximum similarity exceeds the predetermined threshold, the recognition processing section 33 recognizes a character of the reference waveform data or the extended waveform data corresponding to the maximum similarity as a character of the segmented waveform data. The recognition processing section 33 executes the recognition processing for each of the segmented waveform data to recognize the magnetic ink characters MC printed on the paper PA.

The recognition processing section 33 may perform the comparison with the template stepwise. For example, the recognition processing section 33 compares the segmented waveform data with the reference waveform data of the characters first and selects characters having higher similarities of the waveform data. Subsequently, the recognition processing section 33 compares the segmented waveform data with the extended waveform data of the selected characters and calculates similarities of the selected characters. The recognition processing section 33 recognizes a character of the reference waveform data or the extended waveform data having a maximum value of the similarity out of the calculated similarities. The characters having higher similarities may be absolutely determined using a threshold or the like or may be relatively determined by comparing the similarities of the characters. A character to be selected is not limited to one character and may be a plurality of characters.

The output processing section 34 outputs a result of the recognition of the magnetic ink characters MC by the recognition processing section 33 to the display section 25. An output destination of the recognition result is not limited to the display section 25. For example, the output processing section 34 may output the recognition result of the recognition processing section 33 to the storing section 24 (store the recognition result in the storing section 24). The output processing section 34 may output (transmit) the recognition result of the recognition processing section 33 to an external device via a not-illustrated communication device.

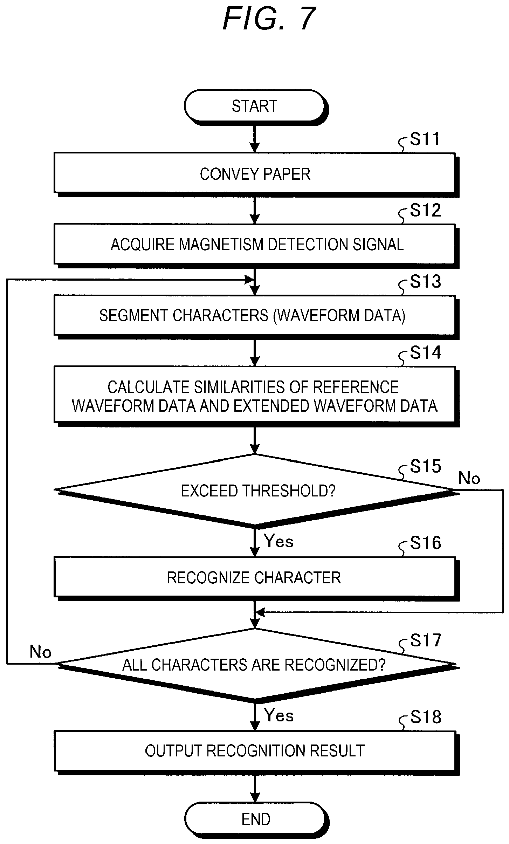

The operation of the magnetic-ink-character recognizing device 1 is explained below with reference to FIGS. 1 and 7. FIG. 7 is a flowchart illustrating an example of the character recognition processing performed by the magnetic-ink-character recognizing device 1.

First, if the paper PA is inserted from the right end side of the paper conveying path 11 illustrated in FIG. 1, the conveyance control section 31 conveys the paper PA to the left end side (step S11). The reading processing section 32 starts reading processing by the magnetic head 13 according to the conveyance of the paper PA and acquires a magnetism detection signal (step S12). The acquired magnetism detection signal is stored in a storage medium such as the RAM 23.

Subsequently, the recognition processing section 33 segments characters (waveform data) from the magnetism detection signal (step S13). Subsequently, the recognition processing section 33 compares the segmented waveform data of the characters and each of the template data (the reference waveform data and the extended waveform data) stored in the storing section 24 and calculates similarities of both the data, respectively (step S14).

Subsequently, the recognition processing section 33 determines whether a value of maximum similarity among the similarities calculated in S14 exceeds a predetermined threshold (step S15) . If determining that the value is equal to or smaller than the threshold (No in step S15), the recognition processing section 33 shifts to step S17. On the other hand, if determining that the value exceeds the threshold (Yes in step S15), the recognition processing section 33 recognizes a character of the reference waveform data or the extended waveform data having the maximum similarity (step S16) and shifts to step S17.

Subsequently, the recognition processing section 33 determines whether all the characters are processed. If unprocessed characters are present (No in step S17), the recognition processing section 33 returns to step S13 and performs segmentation of the next character. If all the characters are processed (Yes in step S17), the output processing section 34 outputs the recognized characters (a character string) (step S18) and ends this processing.

As explained above, the magnetic-ink-character recognizing device 1 performs the character recognition by comparing the waveform data of the characters segmented from the magnetism detection signal with the reference waveform data of the characters and the extended waveform data obtained by compressing or expanding the length in the time axis direction of the reference waveform data. Consequently, even if fluctuation occurs in conveying speed (a conveyance amount) of the paper PA, the magnetic-ink-character recognizing device 1 can perform the character recognition using extended waveform data corresponding to the fluctuation. Therefore, it is possible to improve a character recognition rate.

The embodiment is explained above. However, the embodiment is presented as an example and is not intended to limit the scope of the invention. The new embodiment can be implemented in other various forms. Various omissions, substitutions, and changes can be performed without departing from the scope of the invention. The embodiment and modifications of the embodiment are included in the scope and the gist of the invention and included in the inventions described in claims and the scope of equivalents of the inventions.

For example, in the embodiment, the extended waveform data of the characters is stored in the template data D1. However, the extended waveform data may be dynamically generated from the reference waveform data of the characters. In this case, the recognition processing section 33 functions as a generating section and generates the extended waveform data from the reference waveform data of the characters stored as the template data D1. The recognition processing section 33 executes the character recognition using the reference waveform data of the template data D1 and the extended waveform data generated from the reference waveform data.

The computer programs executed by the magnetic-ink-character recognizing device 1 in the embodiment may be provided while being recorded in a computer-readable recording medium such as a floppy (registered trademark) disk, a CD (Compact Disc), a CD-R (Compact Disc-Recordable), a CD-ROM (Compact Disc Read Only Memory), a DVD (Digital Versatile Disc), an SD memory card, or a USB memory (Universal Serial Bus memory) as a file of an installable form or an executable form.

The computer programs executed by the magnetic-ink-character recognizing device 1 in the embodiment may be stored on a computer connected to a network such as the Internet and provided by being downloaded through the network.

## Claims

1. A magnetic-ink-character recognizing device comprising:
a magnetic head;
a conveying section configured to convey, relative to the magnetic head, a medium on which magnetic ink characters are printed;
an acquiring section configured to acquire a magnetism detection signal read by the magnetic head;
a segmenting section configured to segment waveform data of the magnetic ink characters from the magnetism detection signal;
a first calculating section configured to compare, on the basis of a storing section having stored therein reference waveform data of characters, the waveform data segmented by the segmenting section and the reference waveform data and calculate similarities between the reference waveform data and the segmented waveform data;
a second calculating section configured to compare the waveform data segmented by the segmenting section and extended waveform data obtained by compressing or expanding length in a time axis direction of the reference waveform data according to fluctuation in a conveyance amount of the medium and calculate similarities between the segmented waveform data and the extended waveform data; and
a recognizing section configured to recognize, on the basis of the similarities calculated by the first calculating section and the second calculating section, the magnetic ink characters of the waveform data segmented by the segmenting section.

2. The magnetic-ink-character recognizing device according to claim 1, wherein
the storing section stores, for each of the characters, the reference waveform data and the extended waveform data of the reference waveform data in association with each other, and
the second calculating section compares the waveform data segmented by the segmenting section with the extended waveform data stored in the storing section.

3. The magnetic-ink-character recognizing device according to claim 1, further comprising:
a generating section configured to generate the extended waveform data on the basis of the reference waveform data of the characters, wherein
the second calculating section compares the waveform data segmented by the segmenting section with the extended waveform data generated by the generating section.

4. The magnetic-ink-character recognizing device according to any one of claims 1 to 3, wherein the extended waveform data is obtained by compressing or expanding a part or all of the reference waveform data in the time axis direction.

5. The magnetic-ink-character recognizing device according to any one of claims 1 to 4, wherein the extended waveform data is obtained by, concerning each of the reference waveform data, similarities between which are likely to increase according to compression or expansion in the time axis direction, compressing or expanding length in the time axis direction of the reference waveform data in a deforming direction in which the similarities decrease.

6. The magnetic-ink-character recognizing device according to any one of claims 1 to 5, wherein
the magnetism detection signal is represented by waveform data of a time axis dimension and a voltage axis dimension.

7. The magnetic-ink-character recognizing device according to any one of claims 1 to 6, wherein the magnetism detection signal represents characteristics of the magnetic ink characters.

8. A magnetic ink character recognizing method, comprising:
acquiring a magnetism detection signal read by a magnetic head on a medium on which magnetic ink characters are printed;
segmenting waveform data of magnetic ink characters from the magnetism detection signal;
comparing, on the basis of a storing section having stored therein reference waveform data of characters, the segmented waveform data and the reference waveform data and calculating similarities between the reference waveform data and the segmented waveform data;
comparing the segmented waveform data and extended waveform data obtained by compressing or expanding length in a time axis direction of the reference waveform data according to fluctuation in a conveyance amount of the medium and calculating similarities between the segmented waveform data and the extended waveform data; and
recognizing, on the basis of the calculated similarities, the magnetic ink characters of the segmented waveform data.

9. The method according to claim 8, further comprising:
comparing the waveform data segmented by the segmenting section with the extended waveform data stored in the storing section.

10. The method according to claim 8, further comprising:
generating the extended waveform data on the basis of the reference waveform data of the characters, and
comparing the waveform data segmented by the segmenting section with the extended waveform data generated.

11. The method according to any one of claims 8 to 10, further comprising:
obtaining the extended waveform data by compressing or expanding a part or all of the reference waveform data in the time axis direction.

12. The method according to any one of claims 8 to 11, further comprising:
obtaining the extended waveform data by, concerning each of the reference waveform data, similarities between which are likely to increase according to compression or expansion in the time axis direction, compressing or expanding length in the time axis direction of the reference waveform data in a deforming direction in which the similarities decrease.

13. The method according to any one of claims 8 to 12, wherein the magnetism detection signal is represented by waveform data of a time axis dimension and a voltage axis dimension.

14. The method according to any one of claims 8 to 13, wherein the magnetism detection signal represents characteristics of the magnetic ink characters.

15. A non-transitory computer readable storage medium storing a program causing a computer to execute the method according to any one of claims 8 to 14.
